# EUROPEAN PATENT APPLICATION

(11) **EP 4 428 861 A1**
(43) Date of publication of application: **11.09.2024**
(21) Application number: 24161122.7
(22) Date of filing: 04.03.2024
(51) Int. Cl.: G11C 5/02, G11C 16/04, G11C 16/24, G11C 16/30, H10B 41/27

(54) **THREE-DIMENSIONAL MEMORY DEVICE**

(30) Priority: 09.03.2023 KR 20230031381
(71) Applicant: Samsung Electronics Co., Ltd., Suwon-si, Gyeonggi-do 16677 (KR)
(72) Inventor: LEE, Sungun, 16677 Suwon-si (KR); KWAK, Pansuk, 16677 Suwon-si (KR); YU, Changyeon, 16677 Suwon-si (KR)
(74) Representative: Marks & Clerk LLP

(57) **Abstract**

A memory device includes a stack structure, in which a common source line is formed, and a peripheral circuit structure overlapping the stack structure when viewed in plan view and comprising a common source line driver configured to discharge the common source line. The common source line driver includes a first common source line driving unit, electrically connected to the common source line through a first network and configured to discharge the common source line, and a second common source line driving unit electrically connected to the common source line through a second network, different from the first network, and configured to discharge the common source line. The first common source line driving unit and the second common source line driving unit are controlled independently of each other.

## Description

### BACKGROUND

The present disclosure relates to a semiconductor device, and more particularly, to a memory device having a three-dimensional (3D) structure.

Memory devices are used to store data, and are classified into volatile memory devices and nonvolatile memory devices. An example of the nonvolatile memory devices is a flash memory device.

A memory cell array of a flash memory device has a cell string structure, and one end of the cell string structure is connected to a common source line (CSL). In general, the CSL is connected to a ground terminal through a metal line. Since no resistance component is present in the metal line, voltage drop occurs when current flows in the CSL. Voltage drop caused by a resistance component of the CSL, or the like, may be referred to as CSL noise.

As a structure of a memory cell array has been diversified and complexity has increased, the size of the CSL varies depending on the physical location in the memory cell array. The variation is referred to as CSL noise skew. Such a CSL noise skew makes it difficult to appropriately control CSL noise, and causes a distribution of a threshold voltage of the memory cell to widen.

### SUMMARY

In some aspects, a memory device includes a stack structure in which a CSL is formed and a peripheral circuit structure overlapping the stack structure when viewed in plan view and comprising a CSL driver configured to discharge the CSL.. The CSL driver includes a first CSL driving unit electrically connected to the CSL through a first network and configured to discharge the CSL. The CSL driver also includes a second CSL driving unit electrically connected to the CSL through a second network, different from the first network, and configured to discharge the CSL. The first CSL driving unit and the second CSL driving unit are controlled independently of each other.

In some aspects, a memory device includes a CSL, and a CSL driver connected to the CSL through a plurality of networks and configured to discharge the CSL. The CSL driver selectively activates the plurality of networks based on a physical location of a discharged region of the CSL.

In some aspects, a memory device includes a stack structure in which a plurality of CSLs are formed, and a peripheral circuit structure overlapping the stack structure when viewed in plan view and comprising a CSL driver configured to discharge the plurality of CSLs. The CSL driver includes a first CSL driving unit electrically connected to the plurality of CSLs through a first network and configured to discharge the plurality of CSLs. The CSL driver also includes a second CSL driving unit electrically connected to the plurality of CSLs through a second network, different from the first network, and configured to discharge the plurality of CSL. The first CSL driving unit and the second CSL driving unit are controlled independently of each other.

At least some of the above and other features of the invention are set out in the claims.

### BRIEF DESCRIPTION OF DRAWINGS

The above and other aspects, features, and advantages of the present disclosure will be more clearly understood from the following detailed description, taken in conjunction with the accompanying drawings.
FIG. 1 is a block diagram of an example memory device according to an embodiment.
FIG. 2 illustrates a schematic perspective view of the example memory device of FIG. 1.
FIG. 3 is a diagram illustrating an example of a single memory block, among memory blocks included in a memory cell array of FIG. 2, and an example peripheral circuit corresponding to the single memory block.
FIG. 4 illustrates a plan view of the example memory device of FIG. 1.
FIG. 5 is a diagram illustrating the example memory device taken along line A-A' of FIG. 4.
FIGS. 6 and 7 are diagrams illustrating a CSL noise skew based on an example physical location of FIG. 7.
FIG. 8 is a diagram illustrating an example of a memory device and an example CSL driver according to an embodiment.
FIG. 9 is a diagram illustrating an example operation of the CSL driver of FIG. 8.
FIG. 10 is a diagram illustrating an example of a memory device and an example CSL driver according to an embodiment.
FIG. 11 is a diagram illustrating an example operation of the CSL driver of FIG. 10.
FIG. 12 is a diagram illustrating an example of a memory device and an example CSL driver according to an embodiment.
FIG. 13 is a diagram illustrating a memory device and an example CSL driver according to an embodiment.
FIG. 14 is a diagram illustrating an example operation of the CSL driver of FIG. 13.
FIG. 15 is a block diagram of an example memory device according to an embodiment.
FIG. 16 is a diagram illustrating a CSL skew based on a physical location of a bitline.
FIG. 17 is a diagram illustrating an example operation of the memory device of FIG. 15.
FIG. 18 is a block diagram of an example memory device according to an embodiment.
FIG. 19 illustrates a schematic perspective view of an example memory device according to an embodiment.
FIG. 20 illustrates a plan view of the example memory device of FIG. 19.

### DETAILED DESCRIPTION

Hereinafter, example embodiments will be described with reference to the accompanying drawings.

A memory device according to an example embodiment to be described below may include a CSL driver discharging a CSL. The CSL driver may be electrically connected to the CSL through a plurality of networks. When the CSL is discharged, the memory device according to an example embodiment may adjust the number of activated networks in consideration of a level of CSL noise based on a physical location. Accordingly, a skew of the CSL noise may be reduced, so that the memory device may stably operate.

### [Memory device capable of improving CSL noise skew between blocks]

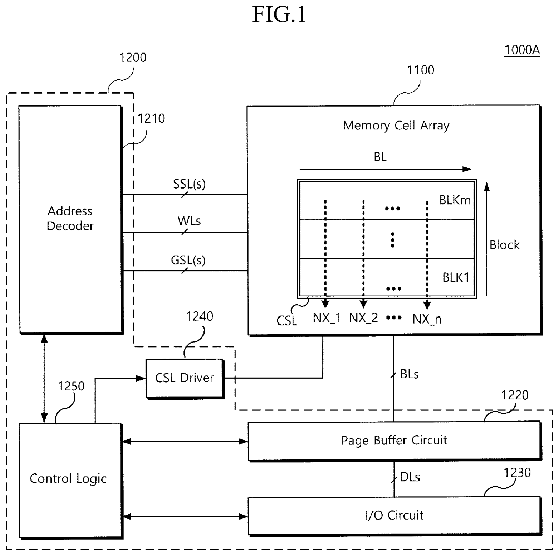

FIG. 1 is a block diagram of an example memory device 1000A according to an example embodiment. As an example, FIG. 1 illustrates a memory device 1000A, capable of improving a CSL noise skew between memory blocks.

The memory device 1000A according to an example embodiment may include a plurality of column networks NX_1 to NX_n discharging a CSL. Each of the plurality of column networks NX_1 to NX_n may be formed across memory blocks BLK1 to BLKm, and may electrically connect the CSL to a CSL driver 1240. When the CSL is discharged, the memory device 1000A may adjust the number of activated column networks, among the plurality of column networks NX_1 to NX_n, in consideration of a level of CSL noise based on physical locations of the plurality of column networks NX_1 to NX_n. Accordingly, the CSL skew between memory blocks may be reduced, so that the memory device 1000A may stably operate.

A more detailed description is provided with reference to FIG. 1. The memory device 1000A may include a memory cell array 1100 and a peripheral circuit 1200.

The memory cell array 1100 may be connected to a page buffer circuit 1220 through bitlines BL, and may be connected to an address decoder 1210 through wordlines WL, string select lines SSL, and ground select lines GSL. The memory cell array 1100 may include a plurality of memory cells, and the memory cells may be, for example, flash memory cells. However, example embodiments are not limited thereto, and a plurality of memory cells may be resistive memory cells such as resistive RAM (ReRAM) cells, phase change RAM (PRAM) cells, or magnetic RAM (MRAM) cells.

The memory cell array 1100 may include a plurality of memory blocks. Each of the memory blocks may have a two-dimensional (2D) structure or a 3D structure. In a memory blocks having a 2D structure (or a horizontal structure), memory cells are formed in a horizontal direction with respect to a substrate. On the other hand, in a memory block having a 3D structure (or a vertical structure), memory cells are formed in a vertical direction with respect to a substrate. Multi-bit data may be stored in each memory cell.

The peripheral circuit 1200 may be disposed adjacent to the memory cell array 1100. For example, the peripheral circuit 1200 may be disposed to be perpendicular to the memory cell array 1100 to overlap the memory cell array 1100 when viewed in plan view. According to an embodiment, the peripheral circuit 1200 and the memory cell array 1100 may be formed in a cell-over-periphery (COP) manner. According to another embodiment, the peripheral circuit 1200 and the memory cell array 1100 may be formed in a chip-to-chip (C2C) manner. The peripheral circuit 1200 may include an address decoder 1210, a page buffer circuit 1220, an input/output (I/O) circuit 1230, a CSL driver 1240, and a control logic 1250.

The address decoder 1210 may be connected to the memory cell array 1100 through row lines. The row lines may include select lines, such as one or more string select lines SSLs and one or more ground select line GSLs, and wordlines WLs. In response to control of the control logic 1250, the address decoder 1210 may select one of a plurality of memory blocks, select one of wordlines WLs of the selected memory block, and select one of a plurality of string select lines SSLs.

The page buffer circuit 1220 may be connected to the memory cell array 1100 through column lines. The column lines may include, for example, a bitline BL. The page buffer circuit 1220 may temporarily store data to be programmed into the selected page or data read from the selected page.

The input/output circuit 1230 may be connected to the page buffer circuit 1220 through data lines DLs and connected to an external entity through an input/output line. The input/output circuit 1230 may receive data to be programmed into a selected memory cell of the memory cell array 1100 from an external entity during a program operation, and may transmit data read from a selected memory cell to an external entity during a read operation.

The CSL driver 1240 may apply a ground voltage or a common source voltage (for example, a power supply voltage) to the CSL based on the control of the control logic 1250. For example, the CSL may be disposed to overlap at least a portion of the memory blocks BLK1 to BLKm when viewed in plan view. The CSL driver 1240 may apply a battery voltage to the CSL to discharge the CSL.

In an example embodiment, the CSL driver 1240 may be electrically connected to the CSL through the plurality of column networks NX_1 to NX_n. Each of the plurality of column networks NX_1 to NX_n may provide a path for discharging the CSL and may be formed across the memory blocks BLK1 to BLKm.

When the CSL is discharged, the CSL driver 1240 may adjust the number of column networks to be activated, among the plurality of column networks NX_1 to NX_n in consideration of a level of CSL noise based on physical locations of the memory blocks BLK1 to BLKm.

In an example embodiment, in the case of a memory block in which a level of CSL noise is relatively low, among the memory blocks BLK1 to BLKm, the CSL driver 1240 may activate a relatively small number of column networks. For example, as will be described below, the closer the memory block is to a plate CSL contact PCC and/or a through-hole via THV, the lower the level of the CSL noise corresponding to the memory block may be. Accordingly, when the CSL is discharged, a noise reduction degree of the CSL corresponding to the memory block may be relatively small.

In an example embodiment, in the case of a memory block in which a level of CSL noise is relatively high, among the memory blocks BLK1 to BLKm, the CSL driver 1240 may activate a relatively large number of column networks. For example, the farther the memory block is from a plate CSL contact (PCC) and/or a through-hole via (THV), the higher a level of the CSL noise corresponding to the memory block may be. Accordingly, when the CSL is discharged, a noise reduction degree of the CSL corresponding to the memory block may be relatively large.

As described above, a relatively small number of column networks may be activated for a memory block in a physical location in which the level of the CSL noise is relatively low, and a relatively large number of column networks may be activated for a memory block in a physical location in which the level of the CSL noise is relatively high. Thus, the memory device 1000A according to an example embodiment may improve a CSL noise skew between memory blocks. As a result, the memory device 1000A may stably operate.

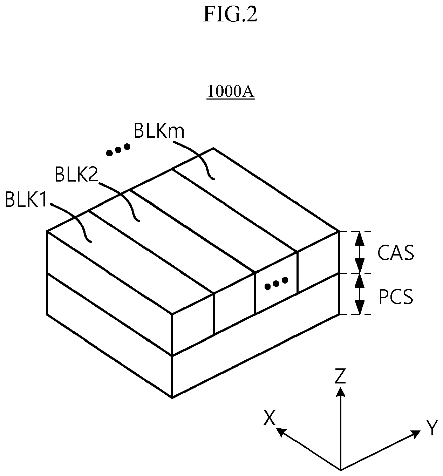

FIG. 2 illustrates a schematic perspective view of the example memory device 1000A of FIG. 1. FIG. 2 shows three directional axes X, Y, Z. These are example directions, relative to the memory device 1000A, and do not imply any particular orientation of the memory device 1000A.

Referring to FIG. 2, the memory device 1000A may include a cell array structure CAS and a peripheral circuit structure PCS overlapping each other in a vertical direction (a Z-direction).

The cell array structure CAS may include the memory cell array 1100 described with reference to FIG. 1. The cell array structure CAS may include a plurality of memory blocks BLK1 to BLKm. Each of the plurality of memory blocks BLK1 to BLKm may include three-dimensionally arranged memory cells. However, this is merely an example, and the plurality of memory blocks BLK1 to BLKm may have a 2D structure.

The peripheral circuit structure PCS may include the peripheral circuit 1200 described with reference to FIG. 1. For example, the peripheral circuit structure PCS may include the CSL driver 1240 (see FIG. 1), and the CSL driver 1240 formed in the peripheral circuit structure PCS may be electrically connected to a CSL in the cell array structure CAS.

In an example embodiment, the CSL driver 1240 in the peripheral circuit structure PCS may discharge the CSL in the cell array structure CAS. In this case, the CSL driver 1240 may adjust the number of column networks to be activated, in consideration of the level of CSL noise based on physical locations of the memory blocks BLK1 to BLKm. As a result, a CSL noise skew may be improved.

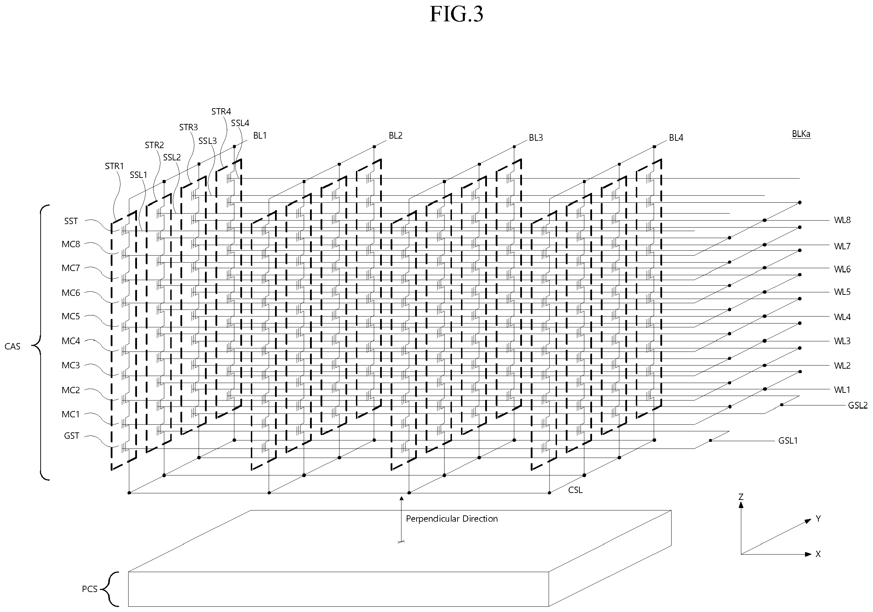

FIG. 3 is a diagram illustrating an example of a single memory block BLKa, which may be one of the memory blocks included in the memory cell array 1100 of FIG. 2, and a peripheral circuit corresponding to the single memory block BLKa.

Referring to FIG. 3, the memory block BLKa may include a plurality of strings STR1, STR2, ... (collectively referred to as STR), disposed in rows and columns. The plurality of strings STR may be commonly connected to a CSL. In FIG. 3, the CSL is illustrated as being connected to lower ends of the strings STR. However, it is possible in some embodiments to electrically connect the CSL to the lower ends of the strings STR, and the CSL is not limited to being physically disposed on the lower ends of the strings STR. As an example, in FIG. 3, the strings STR are illustrated as being arranged in a 4-by-4 array, but the memory block BLKa may include a smaller or larger number of strings.

Strings in each row may be commonly connected to a ground select line GSL1 or GSL2. For example, strings in first and second rows may be commonly connected to the first ground select line GSL1, and strings in third and fourth rows may be commonly connected to the second ground select line GSL2. However, this is merely an example, and four different ground select lines may be provided and strings of each row may be implemented to be connected to different ground select lines.

Strings in each row may be connected to corresponding string select lines, among first to fourth string select lines SSL1 to SSL4. Cell strings in each column may be connected to corresponding bitlines, among first to fourth bitlines BL1 to BL4.

Each string may include at least one ground select transistor GST connected to the ground select line GSL1 or GSL2, a plurality of memory cells MC1 to MC8, respectively connected to a plurality of wordlines WL1 to WL8, and string select transistors SST, respectively connected to string select lines SSL1, SSL2, SSL3, and SSL4.

In each string, a ground select transistor GST, memory cells MC1 to MC8, and string select transistors SST may be connected in series in a direction, perpendicular to a peripheral circuit region, and may be sequentially stacked in the direction, perpendicular to the peripheral circuit region.

Continuing to refer to FIG. 3, at least a portion of a peripheral circuit 1200 (see FIG. 1) may be disposed on a lower end of the memory block BLKa. Circuit devices of the peripheral circuit 1200, disposed on the lower end of the memory block BLKa, may constitute a peripheral circuit structure PCS. For example, the peripheral circuit structure PCS may include a CSL driver 1240 (see FIG. 1), and the CSL driver 1240 may be electrically connected to a CSL to discharge the CSL.

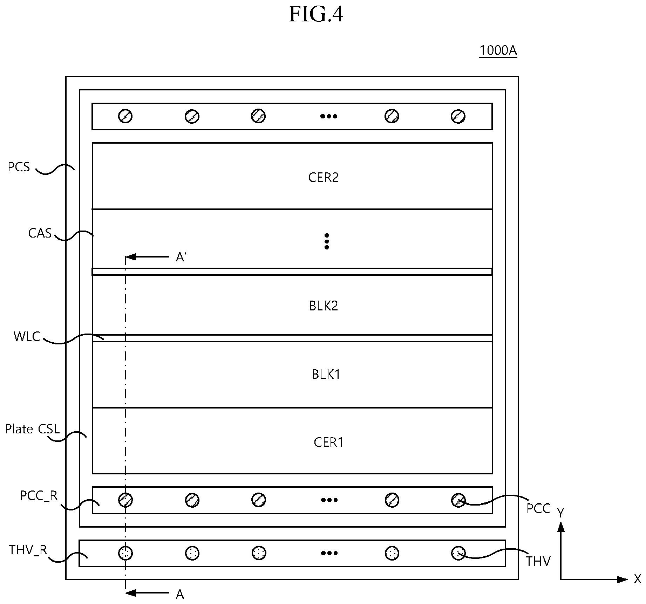

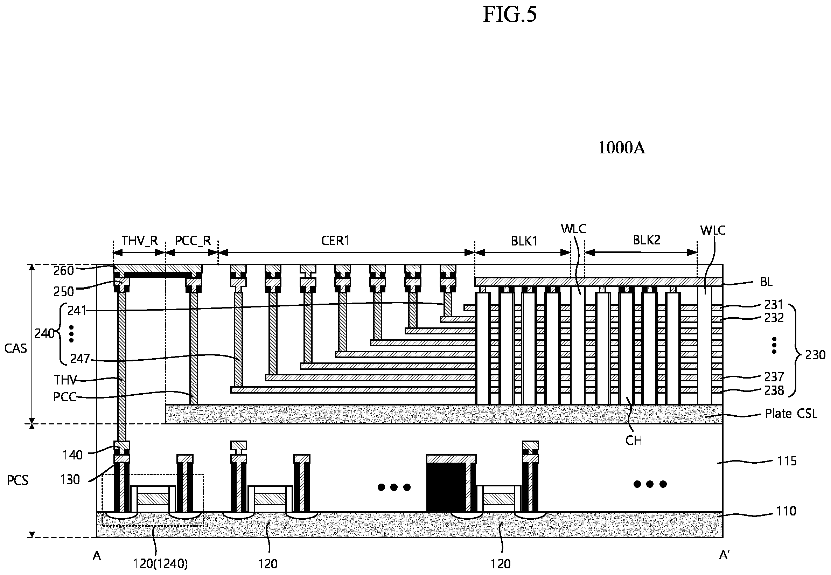

FIG. 4 illustrates a plan view of the example memory device 1000A of FIG. 1, and FIG. 5 is a diagram illustrating the example memory device taken along line A-A' of FIG. 4.

For ease of description, in the present embodiment, the memory device 1000A has a COP structure in which a cell array structure CAS is disposed on a peripheral circuit structure PCS. In addition, for ease of description, in the present embodiment, a CSL of the memory device 1000A is a plate CSL Plate CSL extending in the form of a plate in plan view.

Referring to FIG. 4, the memory device 1000A may include a peripheral circuit structure PCS and a cell array structure CAS, and the cell array structure CAS may overlap the peripheral circuit structure PCS.

A through-electrode region THV_R may extend in a first direction (an X-direction), and may include a plurality of through-vias THVs arranged in the first direction (the X-direction). Each of the plurality of through-vias THVs may be connected to a corresponding plate common contact PCC. For ease of description, in FIG. 4, the number of the plurality of through-vias THVs and the number of the plurality of plate common contacts PCC are illustrated as being the same. However, this is merely an example and, in some embodiments, the number of through-vias THVs may be more or less than the number of the plate common contacts PCC.

The through-electrode regions THV_R may be formed to not overlap the plate CSL Plate CSL. For example, the through-electrode region THV_R may be defined within the peripheral circuit structure PCS. However, this is merely an example, and at least a portion of the through-electrode region THV_R may be formed to overlap the plate CSL Plate CSL when viewed in plan view.

A first plate contact plug region PCC_R1 may be disposed between the through-electrode region THV_R and a first cell extension region CER1. The first plate contact plug region PCC_R1 may extend in the first direction (the X-direction), and may include a plurality of plate common source contacts PCCs arranged in the first direction (the X-direction).

The first plate contact plug region PCC_R1 may overlap the plate common source line Plate CSL. For example, the first plate contact plug PCC_R1 may be defined within the cell array structure CAS and may be connected to the plate common source line Plate CSL. However, this is merely an example, and at least a portion of the first plate contact plug region PCC_R1 may be formed to avoid overlapping the plate common source line Plate CSL when viewed in plan view.

The first cell extension region CER1 may be disposed on one side of a plurality of memory blocks BLK1 to BLKm. For example, the first cell extension region CER1 may extend in the first direction (the X-direction) in which a block separation region WLC extends. As will be described later, a plurality of wordlines 220 will be stacked in the form of staircases in the first cell extension region CER1.

Each of the plurality of memory blocks BLK1 to BLKm may extend in the first direction (the X-direction). Also, each of the plurality of memory blocks BLK1 to BLKm may be arranged in a second direction (a Y-direction). The plurality of memory blocks BLK1 to BLKm may overlap the plate common source line Plate CSL, and may be separated from each other by the block separation region WLC extending in the first direction (the X-direction).

A second cell extension region CER2 may be disposed on the other side of the plurality of memory blocks BLK1 to BLKm. Similarly to the first cell extension region CER1, the second cell extension region CER2 may extend in the first direction (the X-direction), and a plurality of wordlines 220 may be stacked in the form of staircases in the second cell extension region CER2.

A second plate contact plug region PCC_R2 may be disposed around the second cell extension region CER2. Similarly to the first plate contact plug region PCC_R1, the second plate contact plug region PCC_R2 may include a plurality of plate common source contacts PCCs arranged in the first direction (the X-direction), and may be electrically connected to the plate common source line Plate CSL.

For ease of description, in FIG. 4, a single through-electrode region THV_R is illustrated as being formed in the memory device 1000A. However, this is merely an example, and example embodiments are not limited thereto. Alternatively, a first through-electrode region and a second through-electrode region, respectively adjacent to the first plate contact plug region PCC_R1 and the second plate contact plug region PCC_R2, may be formed in the memory device 1000A.

Referring to FIGS. 4 and 5, the cell array structure CAS may be disposed on the peripheral circuit structure PCS. The peripheral circuit structure PCS may include a substrate 110, a plurality of peripheral circuit devices 120, and metal interconnections 130 and 140.

The substrate 110 may be in the form of a plate extending along a plane defined by the first and second directions (the X-axis and Y-axis directions). The substrate 110 may include a semiconductor material, for example, a group IV semiconductor, a group III-V compound semiconductor, or a group II-VI oxide semiconductor. For example, the group IV semiconductor may include silicon (Si), germanium (Ge), or silicon germanium (SiGe). The substrate 110 may be provided as a bulk wafer or an epitaxial layer. In another embodiment, the substrate 110 may include a silicon-on-insulator (SOI) substrate or a germanium-on-insulator (GeOI) substrate.

A plurality of peripheral circuit devices 120 may be disposed on the substrate 110. The plurality of peripheral circuit devices 120 may constitute the peripheral circuit 1200 of FIG. 1. In an example embodiment, for example, a portion of the plurality of peripheral circuit devices 120 may constitute the CSL driver 1240 of FIG. 1. The CSL driver 1240 may be electrically connected to the plate CSL Plate CSL through a through-via THV and a plate common source contact PCC, and may discharge the plate CSL Plate CSL.

An interlayer insulating layer 115, including one or more insulating layers, may be disposed on the substrate 110. The interlayer insulating layer 115 may be formed to cover the plurality of peripheral circuit devices 120. The interlayer insulating layer 115 may include an insulating material such as a silicon oxide or a silicon nitride.

A plurality of metal interconnections 130 and 140, connecting the plurality of circuit devices 120, may be provided in the interlayer insulating layer 115. For example, the plurality of metal interconnections 130 and 140 may include a first metal interconnection 130, connected to each of the plurality of circuit devices 120, and a second metal interconnection 140 formed on the first metal interconnection 130. The plurality of metal interconnections 130 and 140 may include at least one of various conductive materials. For example, the first metal interconnection 130 may be formed of tungsten having relatively high electrical resistivity, and the second metal interconnection 140 may be formed of copper having relatively low electrical resistivity.

Continuing to refer to FIGS. 4 and 5, the cell array structure CAS may include a plurality of memory blocks BLK1 to BLKm formed on the plate CSL Plate CSL.

The plate CSL Plate CSL may be disposed on the interlayer insulating layer 115. The plate CSL Plate CSL may be in the form of a plate extending along a plane defined by the first and second directions (the X-axis and Y-axis directions). The plate CSL Plate CSL may serve as the CSL of FIG. 3 to supply current to memory blocks formed in the cell array structure CAS. In some embodiments, the plate CSL Plate CSL may be referred to as a CSL or may be referred to as a sub-polysilicon structure.

The plate CSL Plate CSL may include at least one of silicon (Si), germanium (Ge), silicon germanium (SiGe), gallium-arsenide (GaAs), indium gallium arsenide (InGaAs), aluminum gallium arsenide (AlGaAs), or combinations thereof. Alternatively, the plate CSL Plate CSL may include a semiconductor doped with N-type impurities. Alternatively, the plate CSL Plate CSL may have a crystal structure including at least one selected from a single crystal structure, an amorphous structure, and a polycrystalline structure. Alternatively, the plate CSL Plate CSL may include polysilicon or a conductive material. The plate CSL Plate CSL may have a single-layer structure or a multilayer structure.

The plurality of memory blocks BLK1 to BLKm may be formed on the plate CSL Plate CSL. Each of the plurality of memory blocks BLK1 to BLKm may include three-dimensionally arranged memory cells. Each of the plurality of memory blocks BLK1 to BLKm may include a plurality of channel structures VS and may be connected to a plurality of wordlines 230 (231 to 238).

The plurality of wordlines 230 may be stacked on an upper surface of the plate CSL Plate CSL. String select lines and ground select lines may be disposed above and below the plurality of wordlines 230, and wordlines 230 may be disposed between the string select lines and the ground select line.

A plurality of channel structures CH may be disposed on the plate CSL Plate CSL. Each of the plurality of channel structures CH may extend in a direction perpendicular to the plate CSL Plate CSL to penetrate through the wordlines 230. The channel structure CH may include a data storage layer, a channel layer, and a buried insulating layer. The channel layer may be connected to a bitline. The bitline BL may extend in the second direction (the Y-axis direction).

In the first cell extension region CER1, the wordlines 230 may extend in the second direction (the Y-axis direction), parallel to the upper surface of the plate CSL Plate CSL, and may be connected to a plurality of cell contact plugs 240 (241 to 247). A first metal interconnection 250 and a second metal interconnection 250 may be sequentially connected to upper portions of the cell contact plugs 240 connected to the wordlines 230. The cell contact plugs 240 may be electrically connected to, for example, a row decoder included in the peripheral circuit structure PCS.

A plate common source contact PCC may be disposed in the plate contact plug region PCC_R. The plate common source contact PCC may be formed of, for example, a conductive material such as metal, metal compound, or doped polysilicon. The plate common source contact PCC may be electrically connected to the plate CSL Plate CSL. For example, the plate common source contact PCC may extend from an upper surface of the plate CSL Plate CSL in a direction perpendicular to the plate CSL Plate CSL. A first metal interconnection 250 and a second metal interconnection 260 may be sequentially stacked on the plate common source contact PCC.

A through-via THV may be disposed in the through electrode region THV_R. For example, the through-via THV may be formed of a material, the same as or similar to a material of the plate common source contact PCC. For example, the through-via THV may be formed of a conductive material such as metal, metal compound, or doped polysilicon.

The through-via THV may be disposed outside the plate CSL Plate CSL to avoid overlap the plate CSL Plate CSL. From the outside of the CSL Plate CSL, the through-via THV may penetrate through the cell array structure CAS to be connected to the CSL driver 1240 of the peripheral circuit structure PCS. However, this is merely an example and, in some embodiments, the through-via THV may be formed to penetrate through the plate CSL Plate CSL.

The first metal interconnection 250 and the second metal interconnection 260 may be sequentially stacked on the through-via THV. The second metal interconnection 260 may extend in a second direction (a Y-axis direction) to connect the through-via THV and the plate common source contact PCC to each other. Accordingly, a discharge path including the plate CSL Plate CSL, the plate common source contact PCC, the through-electrode THV, and the CSL driver 1240 may be formed.

In FIGS. 4 and 5, the peripheral circuit structure PCS has been illustrated and described as including only the first metal interconnection 130 and the second metal interconnection 140, and the cell array structure CAS has also been illustrated and described as including the first metal interconnection 250 and the second metal interconnection 260, but example embodiments are not limited thereto. In some embodiments, one or more additional metal interconnections may be further formed on the second metal interconnection 140 or 260. In this case, the second metal interconnection 140 or 260 may be formed of aluminum. In addition, at least a portion of the additional metal interconnections formed on the second metal interconnection 140 or 260 may be formed of copper, which has lower electrical resistivity than aluminum of the second metal interconnection 140 or 260.

Also, in FIGS. 4 and 5, the memory device 1000A has been illustrated and described as having a COP structure in which the cell array structure CAS is disposed on the peripheral circuit structure PCS, but example embodiments are not limited thereto. Alternatively, the memory device 1000A may have a chip-to-chip (C2C) structure, rather than the COP structure. The C2C structure may refer to a structure in which an upper chip including a cell array structure CAS is fabricated on a first wafer, a lower chip including a peripheral circuit structure PCS is fabricated on a second wafer, different from the first wafer, and the upper chip and the lower chip are connected to each other in a bonding manner. For example, the bonding manner may refer to a manner of electrically connecting a bonding metal formed on an uppermost metal layer of the upper chip and a bonding metal formed on an uppermost metal layer of the lower chip to each other. For example, when the bonding metal is formed of copper (Cu), the bonding manner may be a Cu-to-Cu bonding manner and the bonding metal may also be formed of aluminum (Al) or tungsten (W).

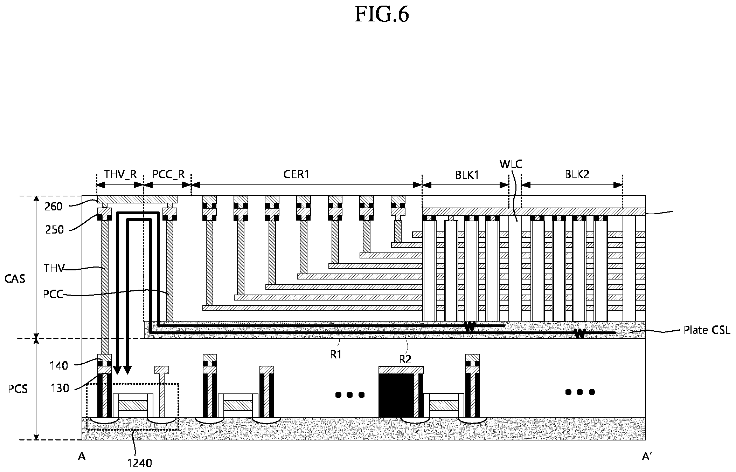

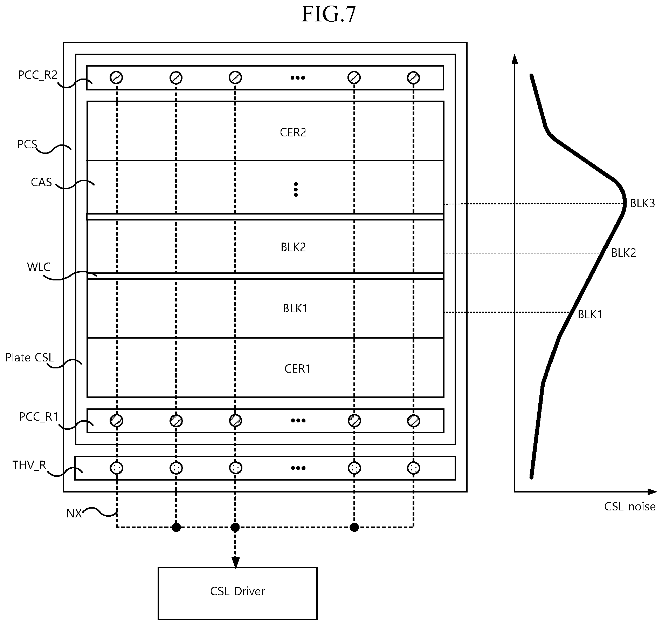

FIGS. 6 and 7 are diagrams illustrating a CSL noise skew based on an example physical location of FIG. 7. For ease of description, in the present embodiment, a memory device of FIGS. 6 and 7 is formed in a COP structure, as illustrated in FIG. 5. In addition, in the present embodiment, a plate CSL Plate CSL is discharged through a single network.

Referring to FIG. 6, when current flows through the plate CSL Plate CSL, CSL noise may occur due to a resistance component of the plate CSL Plate CSL. For ease of description, in the present embodiment, CSL noise corresponding to a first memory block BLK1 adjacent to a first cell region is "first noise resistance R1" and CSL noise corresponding to a second memory block BLK2 physically separated from the first memory block BLK1 is "second noise resistance R2."

In this case, a discharge path corresponding to the second memory block BLK2 is longer than a discharge path corresponding to the second memory block BLK1, so that the second noise resistance R2 may be higher than the first noise resistor R1. For example, in a situation in which the CSL driver 1240 is electrically connected to the plate CSL Plate CSL via the plate common source contact PCC and/or through-via THV, the closer the physical location of a memory block is to the plate CSL contact PCC and/or through-hole via THV, the lower the level of the CSL noise corresponding to the memory block may be.

As an example, in the present embodiment, the first to third memory blocks BLK1 to BLK3 are arranged to be close to a first plate contact plug region PCC_R1 in order, as illustrated in FIG. 7. In this case, a level of CSL noise corresponding to the first memory block BLK1 disposed to be closest to the first plate contact plug region PCC_R1 is lowest, and a level of CSL noise corresponding to the third memory block BLK3 disposed to be most distant from the first plate contact plug region PCC_R1 is highest.

In addition, CSL noise may occur irregularly and nonlinearly depending on a physical structure of a memory device. For example, a level of the CSL noise may vary depending on the location and number of plate common source contacts PCC and/or through-vias THV.

Such CSL noise skew not only may make it difficult to control the memory device, but also may cause a distribution of a threshold voltage of memory cells to widen. Accordingly, there is demand for improvement of the CSL noise skew.

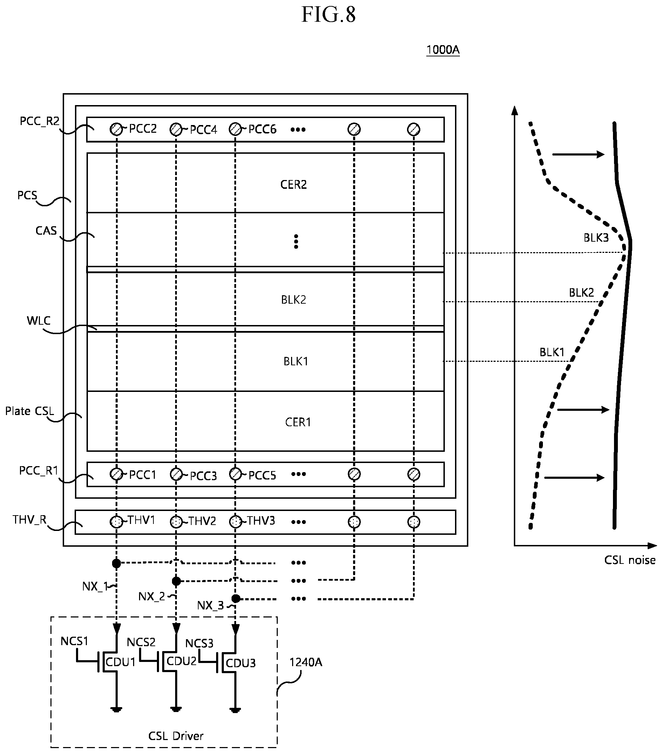

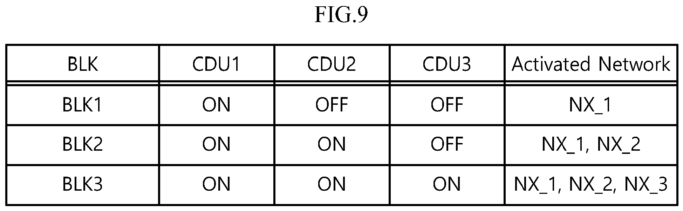

FIG. 8 is a diagram illustrating an example of a memory device 1000A and an example CSL driver 1240A according to an embodiment, and FIG. 9 is a diagram illustrating an example operation of the CSL driver 1240A of FIG. 8.

For ease of description, similarly to FIGS. 6 and 7, in the present embodiment, first to third memory blocks BLK1 to BLK3 are disposed to be close to a first plate contact plug region PCC_R in order. In addition, in the present embodiment, three column networks NX_1 to NX_3 are formed to discharge a plate CSL Plate CSL.

Referring to FIG. 8, the memory device 1000A according to an example embodiment may include a plurality of column networks NX_1 to NX_3 to discharge the plate CSL Plate CSL. Each of the plurality of column networks NX_1 to NX_3 may be formed across the memory blocks BLK1 to BLK3, and may be connected to the CSL driver 1240A via a first plate contact plug region PCC_R1 and a through-electrode region THV_R. For example, the first column network NX_1 may be electrically connected to the plate CSL Plate CSL through a first through-via THV1 and first and second plate common source contacts PCC1 and PCC2. The second column network NX_2 may be electrically connected to the plate CSL Plate CSL through a second through-via THV2 and third and fourth plate common source contacts PCC3 and PCC4. The third column network NX_3 may be electrically connected to the plate CSL Plate CSL through a third through-via THV3 and fifth and sixth plate common source contacts PCC5 and PCC6.

In this case, the CSL driver 1240A may include a plurality of CSL driving units CDU1 to CDU3, and each of the plurality of CSL driving units CDU1 to CDU3 may be controlled independently of each other. Accordingly, when the CSL is discharged, the memory device 1000A according to an example embodiment may adjust the number of activated column networks, among the plurality of column networks NX_1 to NX_n, in consideration of a level of CSL noise based on physical locations of the memory blocks BLK1 to BLKm.

A more detailed description will be provided with reference to FIGS. 8 and 9. In the present embodiment, a discharge operation is performed on the plate CSL Plate CSL, in relation to an operation of the first memory block BLK1. Since the first memory block BLK1 is disposed to be relatively adjacent to the first plate contact plug region PCC_R1, a level of the CSL noise of the first memory block BLK1 may be relatively low, as described in FIG. 7. In this case, the control logic 1250 (see FIG. 1) may output the first network control signal NCS1 having a high level and second and third network control signals NCS2 and NCS3 having a low level. Accordingly, the first CSL driving unit CDU1 may be turned on, and the second and third CSL driving units CDU2 and CDU3 may be turned off. Accordingly, only the first column network NX_1 may be activated, and the plate CSL Plate CSL may be discharged through only the first column network NX_1. As a result, the amount of current flowing in a direction from the plate CSL Plate CSL to the CSL driver 1240A is relatively small, so that a noise reduction degree of the plate CSL Plate CSL corresponding to the first memory block BLK1 may be relatively small.

In addition, in relation to an operation of the third memory block BLK3, in the present embodiment, a discharge operation is performed on the plate CSL Plate CSL. Since the third memory block BLK3 is disposed to be relatively distant from the first plate contact plug region PCC_R1, a level of the CSL noise of the third memory block BLK3 may be relatively high, as described in FIG. 7. In this case, as illustrated in FIG. 9, the first to third CSL driving units CDU1 to CDU3 may be turned on to activate the first to third column networks NX_1 to NX_3. As a result, a noise reduction degree of the plate CSL Plate CSL corresponding to the third memory block BLK3 may be greater than that of the first memory block BLK1.

In addition, in the present embodiment, a discharge operation is performed on the plate CSL Plate CSL, in relation to an operation of the second memory block BLK2. Since the second memory block BLK2 is disposed between the first memory block BLK1 and the third memory block BLK3, a level of CSL noise of the second memory block BLK2 may be higher than a level of CSL noise of the first memory block BLK1 and lower than a level of CSL noise of the third memory block BLK3. In this case, as illustrated in FIG. 9, the first and second CSL driving units CDU1 and CDU2 may be turned on, and the third CSL driving unit CDU3 may be turned off. Accordingly, the first and second column networks NX_1 and NX_2 may be activated, and the plate CSL Plate CSL may be discharged through the first and second column networks NX_1 and NX_2. As a result, a noise reduction degree of the plate CSL Plate CSL corresponding to the second memory block BLK2 may be larger than that of the first memory block BLK1 and smaller than that of the third memory block BLK3.

In such a manner, the memory device 1000A according to an example embodiment may activate a relatively smaller number of column networks for a memory block disposed in a physical location in which a level of noise of the plate CSL Plate CSL is relatively low, and may activate a relatively large number of column networks for a memory block disposed in a physical location in which a level of noise of the plate CSL Plate CSI is relatively high. Accordingly, the noise of the plate CSL Plate CSL corresponding to each memory block may be similar to each other regardless of physical locations. As a result, the CSL noise skew between memory blocks may be improved.

In FIG. 8, the CSL driver 1240A has been described as including three CSL driving units. However, this is merely an example, and example embodiments are not limited thereto. For example, the CSL driver 1240A mat be implemented to include two or more driving units.

In addition, in FIG. 8, each of the CSL driving units included in the CSL driver 1240A has been described as being connected to a ground terminal. However, this is merely an example, and example embodiments are not limited thereto. For example, when the amount of current discharged through a plurality of column networks may be controlled depending on a physical location of a memory block, the CSL driver 1240 according to an example embodiment may be implemented in various forms. Hereinafter, other examples of the CSL driver 1240 according to an example embodiment may be described in more detail.

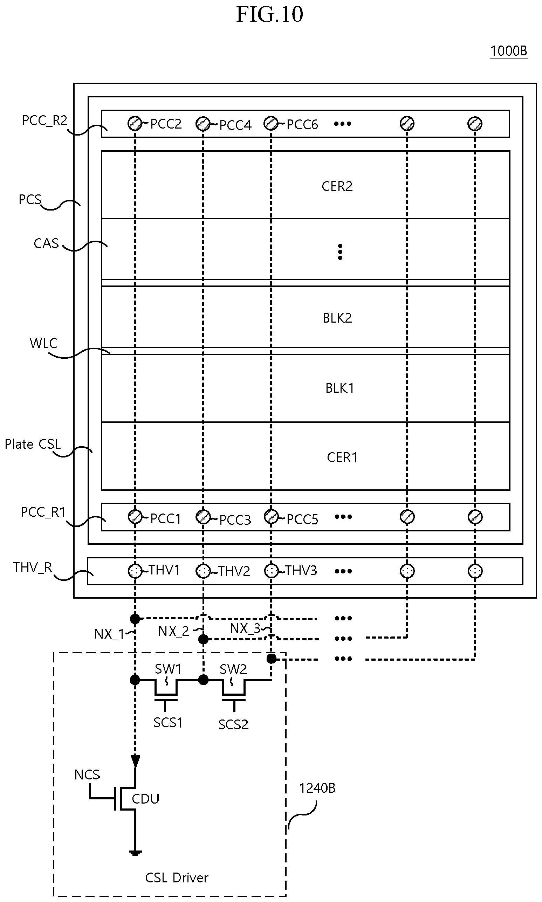

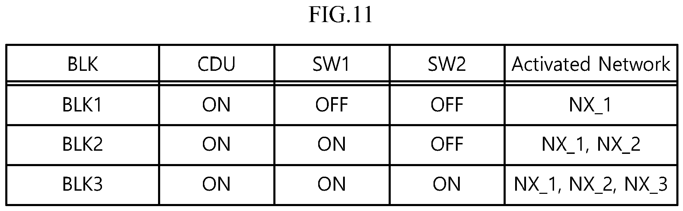

FIG. 10 is a diagram illustrating an example of a memory device 1000B and an example CSL driver 1240B according to an embodiment, and FIG. 11 is a diagram illustrating an example operation of the CSL driver 1240B of FIG. 10.

The memory device 1000B of FIG. 10 is similar to the memory device 1000A of FIG. 8, except for a configuration of the CSL driver 1240B. Therefore, the same or similar components are denoted by the same or similar reference numerals, and redundant descriptions will be omitted below.

Referring to FIG. 10, the CSL driver 1240B may be implemented to include a CSL driving unit CDU and a plurality of switches SW1 and SW2.

The CSL driving unit CDU may be connected between a first column network NX_1 and a ground terminal. The CSL driving unit CDU may be turned on or turned off in response to a network control signal NCS received from the control logic 1250 (see FIG. 1).

The first switch SW1 may be connected between the first column network NX_1 and a second column network NX_2. The first switch SW1 may be turned on or turned off in response to a first switch control signal SCS1 received from the control logic 1250.

The second switch SW2 may be connected between the second column network NX_2 and a third column network NX_3. The second switch SW2 may be turned on or turned off in response to a second switch control signal SCS2 received from the control logic 1250.

Referring to FIG. 11, when a discharge operation is performed on a plate CSL Plate CSL in relation to the operation of the first memory block BLK1, the CSL driving unit CDU may be turned on and the first and second switches SW1 and SW2 may be turned off Accordingly, only the first column network NX_1 may be activated, and the plate CSL Plate CSL may be discharged through only the first column network NX_1. As a result, a noise reduction degree of the plate CSL Plate CSL corresponding to the first memory block BLK1 may be relatively low.

In addition, when a discharge operation is performed on the plate CSL Plate CSL in relation to the operation of the third memory block BLK3, the CSL driving unit CDU and the first and second switches SW1 and SW2 may all turned on. Accordingly, all of the first to third column networks NX_1 to NX_3 may be activated. As a result, a noise reduction degree of the plate CSL Plate CSL corresponding to the third memory block BLK3 may be higher than the noise reduction degree of the plate CSL Plate CSL corresponding to the first memory block BLK1.

In addition, when a discharge operation is performed on the plate CSL Plate CSL in relation to the operation of the second memory block BLK2, the CSL driving unit CDU and the first switch SW1 may be turned on, and the second switch SW2 nay be turned off. Accordingly, the first and second column networks NX_1 and NX_2 may be activated. As a result, a noise reduction degree of the plate CSL Plate CSL corresponding to the second memory block BLK2 may be higher than the noise reduction degree of the plate CSL Plate CSL corresponding to the first memory block BLK1 and lower than the noise reduction degree of the plate CSL Plate CSL corresponding to the third memory block BLK3.

In such a manner, noises of the plate CSL Plate CSL corresponding to the respective memory blocks may be similar to each other regardless of the physical locations of the memory blocks. As a result, the CSL noise skew between the memory blocks may be improved.

In FIGS. 10 and 11, the CSL driver 1240B is illustrated as including a single CSL driving unit and two switches. However, this is merely an example, and example embodiments are not limited thereto. The number of CSL driving units and the number of switches may vary according to example embodiments.

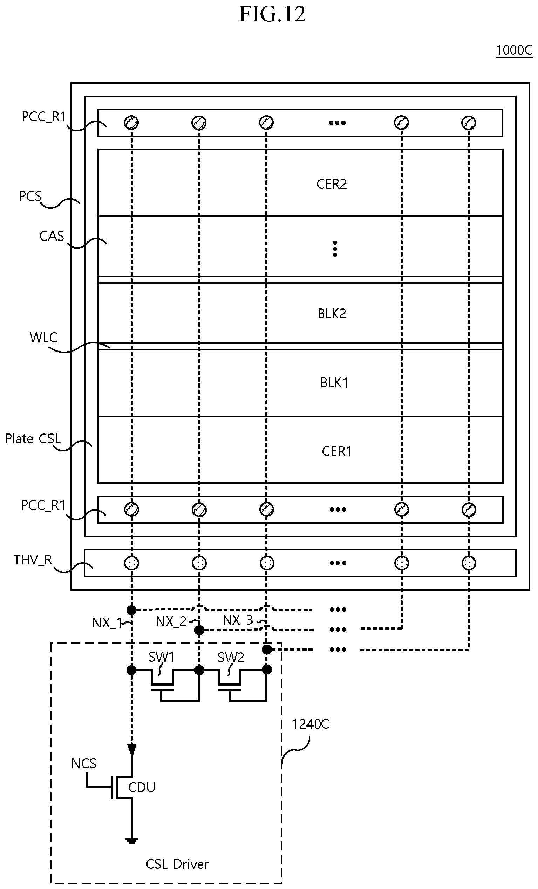

FIG. 12 is a diagram illustrating an example of a memory device 1000C and an example CSL driver 1240C according to an embodiment.

The memory device 1000C of FIG. 12 is similar to the memory device 1000B of FIG. 10, except for a configuration of the CSL driver 1240C. Therefore, the same or similar components are denoted by the same or similar reference numerals, and redundant descriptions will be omitted below.

Referring to FIG. 12, the CSL driver 1240C may be implemented to include a CSL driving unit CDU and a plurality of switches SW1 and SW2.

For example, the first switch SW1 may be connected between the first column network NX_1 and the second column network NX_2, and both a gate and a source of the first switch SW1 may be connected to the second column network NX_2. The second switch SW2 may be connected between the second column network NX_2 and the third column network NX_3, and both a gate and a source of the second switch SW2 may be connected to the third column network NX_3. Since both the first and second switches SW1 and SW2 are implemented as source followers, the amount of current discharged through the second and third column networks NX_2 and NX_3 may vary depending on a physical location of the memory block.

As an example, when a discharge operation is performed on the plate CSL Plate CSL of the first memory block BLK1 in which a level of CSL noise is relatively low, the first and second switches SW1 and SW2 may be turned off or slightly turned on. "Slightly" may mean for example that the switch is partially on, for example half-on, i.e. transmitting half the current that would be transmitted if fully on. Accordingly, a noise reduction degree of the plate CSL Plate CSL corresponding to the first memory block BLK1 may be relatively low.

As another example, when a discharge operation is performed on the plate CSL Plate CSL of the third memory block BLK3 in which a level of CSL noise is relatively high, the first and second switches SW1 and SW2 may be fully turned off or strongly turned on. Accordingly, a noise reduction degree of the plate CSL Plate CSL corresponding to the third memory block BLK3 may be relatively high.

In such a manner, noises of the plate CSL Plate CSL corresponding to respective memory block may be similar to each other regardless of the physical locations of the memory blocks. As a result, a CSL noise skew between the memory blocks may be improved.

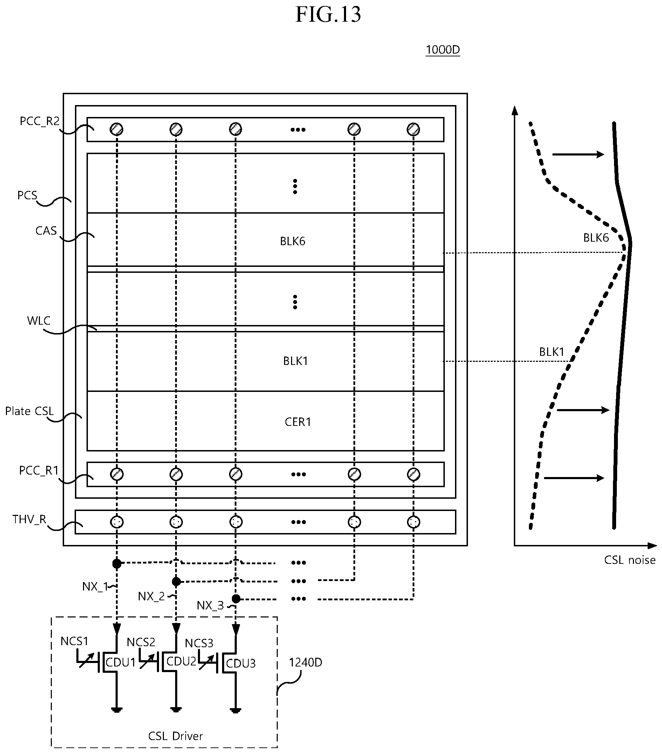

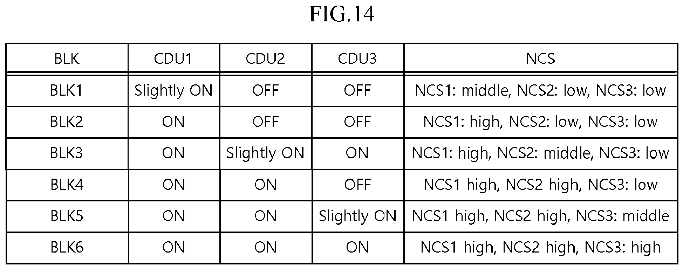

FIG. 13 is a diagram illustrating an example of a memory device 1000D and an example CSL driver 1240D according to an embodiment, and FIG. 14 is a diagram illustrating an example operation of the CSL driver 1240D of FIG. 13.

The memory device 1000D of FIG. 13 is similar to the memory device 1000A of FIG. 8, except that a control signal of the CSL driver 1240D is a variable signal. Therefore, the same or similar components are denoted by the same or similar reference numerals, and redundant descriptions will be omitted below.

Referring to FIG. 13, the CSL driver 1240D may include a plurality of CSL driving units CDU1 to CDU3, and the plurality of CSL driving units CDU1 to CDU3 may be independently controlled by corresponding network control signals NCS1 to NCS3, respectively. In this case, a voltage level of each of the plurality of network control signals NCS1 to NCS3 may vary in consideration of a level of noise based on a physical location of the memory block. Accordingly, a CSL noise skew may be controlled more precisely.

A detailed description will be provided with reference to FIG. 14. In the present embodiment, first to sixth memory blocks BLK1 to BLK6 are disposed in order, and the first memory block BLK1 is disposed to be most adjacent to a plate contact plug region PCC_R1 and the sixth memory block BLK6 is disposed to be most distant from the plate contact plug region PCC_R1.

When a discharge operation is performed on the plate CSL Plate CSL in relation to the operation of the first memory block BLK1, a first network control signal NCS1 having a middle level may be provided. Accordingly, the first CSL driving unit CDU1 may be slightly turned on, and the remaining CSL driving units CDU2 to CDU6 may be turned off. As a result, a noise reduction degree of the plate CSL Plate CSL corresponding to the first memory block BLK1 may be lowest. As above, "slightly" may mean that a given switch is partially on, for example half-on, such that it transmits substantially half of the current that would be transmitted if fully open.

When a discharge operation is performed on the plate CSL Plate CSL in relation to the operation of the second memory block BLK2, the first network control signal NCS 1 having a high level may be provided. Accordingly, the first CSL driving unit CDU1 may be fully turned on, and the remaining CSL driving units CDU2 to CDU6 may be turned off. As a result, a noise reduction degree of the plate CSL Plate CSL corresponding to the second memory block BLK2 may be higher than the noise reduction degree of the plate CSL Plate CSL corresponding to the first memory block BLK1.

When a discharge operation is performed on the plate CSL Plate CSL in relation to the operation of the third memory block BLK3, the first network control signal NCS1 having a high level and the second network control signal NCS2 having a middle level may be provided. Accordingly, the first CSL driving unit CDU1 may be fully turned on, the second CSL driving unit CDU2 may be slightly turned on, and the remaining CSL driving units CDU3 to CDU6 may be turned off. As a result, a noise reduction degree of the plate CSL Plate CSL corresponding to the third memory block BLK3 may be higher than the noise reduction degree of the plate CSL Plate CSL corresponding to the second memory block BLK2.

In a similar manner, voltage levels of the third to sixth network control signals NCS3 to NCS6 may be determined depending on physical locations of the third to sixth memory blocks BLK3 to BLK6. As a result, a CSL noise skew may be controlled more precisely.

In FIGS. 1 to 14, the memory devices according to example embodiments have been illustrated and described as improving a CSL noise skew between memory blocks. For example, a plurality of column networks are illustrated as extending in a second direction (a Y-axis direction) across the memory blocks. However, this is merely an example, and example embodiments are not limited thereto. For example, the memory device according to an example embodiment may improve the CSL noise skew through a plurality of row networks extending in a first direction (an X-axis direction). As another example, the memory device according to an example embodiment may improve the CSL noise skew through a plurality of column networks and a plurality of row networks extending in first and second directions (X-axis and Y-axis directions). Hereinafter, various embodiments will be described in more detail.

### [Memory device, capable of improving CSL noise skew in block]

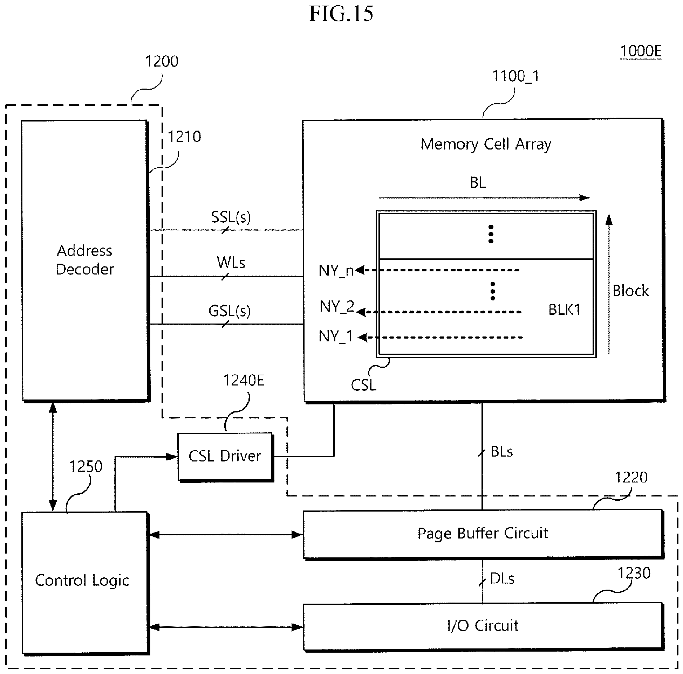

FIG. 15 is a block diagram illustrating an example memory device 1000E according to an example embodiment. The memory device 1000E of FIG. 15 is similar to the memory devices 1000A to 1000D of FIGS. 1 to 14. Therefore, the same or similar components are denoted by the same or similar reference numerals, and redundant descriptions will be omitted below.

Referring to FIG. 15, the memory device 1000E according to an example embodiment may improve a CSL noise skew in a memory block. To this end, the memory device 1000E according to an example embodiment may include a plurality of row networks NY_1 to NY_n discharging a CSL.

Each of the plurality of row networks NY_1 to NY_n may be formed across bitlines BLs, and may electrically connect the CSL to a CSL driver CSL Driver. When the CSL is discharged, the memory device 1000E may the number of activated column networks, among the plurality of row networks NY_1 to NY_n, in consideration of a level of CSL noise based on physical locations of the bitlines BLs. Accordingly, a CSL skew within a memory block may be improved.

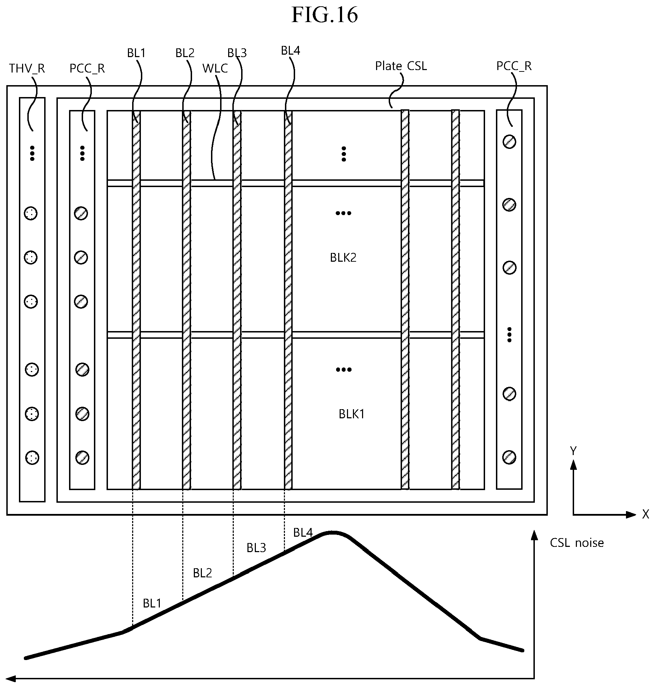

FIG. 16 is a diagram illustrating a CSL noise skew based on physical locations of bitlines. For ease of description, in the present embodiment of FIG. 16, the plate CSL Plate CSL is discharged through a single network.

Referring to FIG. 16, first to fourth bitlines BL1 to BLK4 may be disposed to be close to a plate contact plug region PCC_R in order. In this case, a level of CSL noise corresponding to the first bitline BL1, disposed to be closest to the plate contact plug region PCC_R, is lowest and a level of CSL noise corresponding to the fourth bitline BL4, disposed to be most distant from the plate contact plug region PCC_R, may be highest. Accordingly, a CSL noise skew may occur even within a memory block.

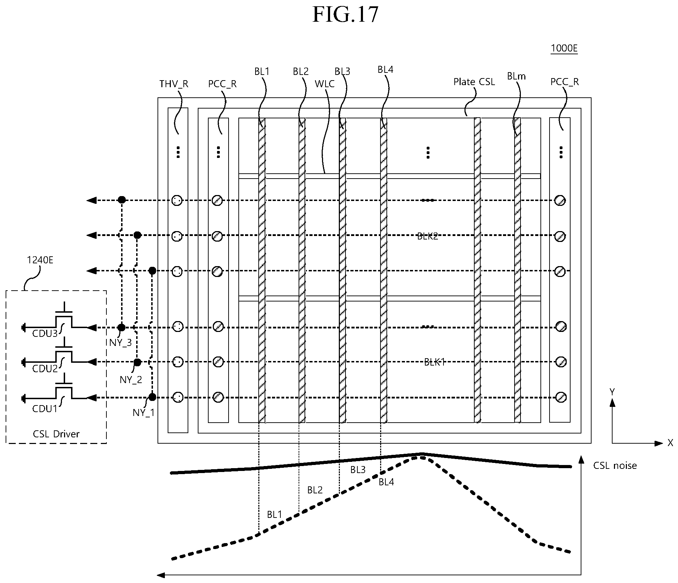

FIG. 17 is a diagram illustrating an operation of the memory device 1000E of FIG. 15. For ease of description, in the present embodiment, three row networks are formed for each memory block to discharge a plate CSL Plate CSL.

Referring to FIG. 17, the memory device 1000E according to an example embodiment may include a plurality of row networks NY_1 to NY_3 to discharge the plate CSL Plate CSL. Each of the plurality of row networks NY_1 to NY_3 may be formed across bitlines BL1 to BLm, and may be connected to a CSL driver 1240E via a plate contact plug region PCC_R and a through-electrode region THV_R.

In this case, the CSL driver 1240E may include a plurality of CSL driving units CDU1 to CDU3, and each of the plurality of CSL driving units CDU1 to CDU3 may be controlled independently of each other. Accordingly, when the CSL is discharged, the memory device 1000E according to an example embodiment may adjust the number of activated row networks, among the plurality of row networks NY_1 to NY_3, in consideration of a level of CSL noise based on physical locations of the bitlines BL1 to BLm. Accordingly, a CSL noise skew within a memory block may be improved.

In FIG. 17, the CSL driver 1240E has been illustrated and described as including the plurality of CSL driving units CDU1 to CDU3. However, this is merely an example, and example embodiments are not limited thereto. According to example embodiments, similarly to the description provided with reference to FIGS. 10 to 14, the CSL driver 1240E may include at least one switch or may be implemented to receive variable control signals from the control logic 1250.

### [Memory device, capable of improving CSL noise skew between blocks and CSL noise skew within block]

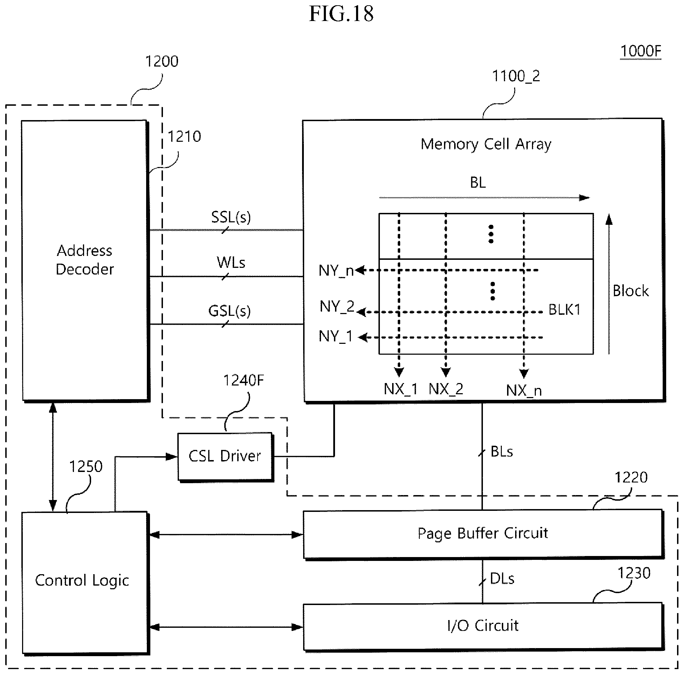

FIG. 18 is a block diagram illustrating a memory device 1000F according to an example embodiment. The memory device 1000F of FIG. 18 is similar to the memory devices 1000A to 1000E of FIGS. 1 to 17. Therefore, the same or similar components are denoted by the same or similar reference numerals, and redundant descriptions will be omitted below.

Referring to FIG. 18, the memory device 1000F according to an example embodiment may improve not only a CSL noise skew between memory blocks but also a CSL noise skew within a memory block. To this end, the memory device 1000F according to an example embodiment may include a plurality of column networks NX_1 to NX_n and a plurality of row networks NY_1 to NY_n to discharge a CSL.

Each of the plurality of column networks NX_1 to NX_n may be formed across the memory blocks BLK1 to BLKm, and may electrically connect a CSL to a CSL driver 1240F. When the CSL is discharged, the memory device 1000F may adjust the number of activated column networks, among the plurality of column networks NX_1 to NX_n, in consideration of a level of CSL noise based on physical locations of the memory blocks BLK1 to BLKm.

Accordingly, not only the CSL skew between memory blocks but also the CSL skew may be improved.

In FIGS. 1 to 18, the memory device is illustrated as including a single plate CSL. However, this is merely an example, and example embodiments may be applied to a memory device including a plurality of plate CSLs, which will be described below in more detail.

### [Memory Device including a plurality of plate CSLs]

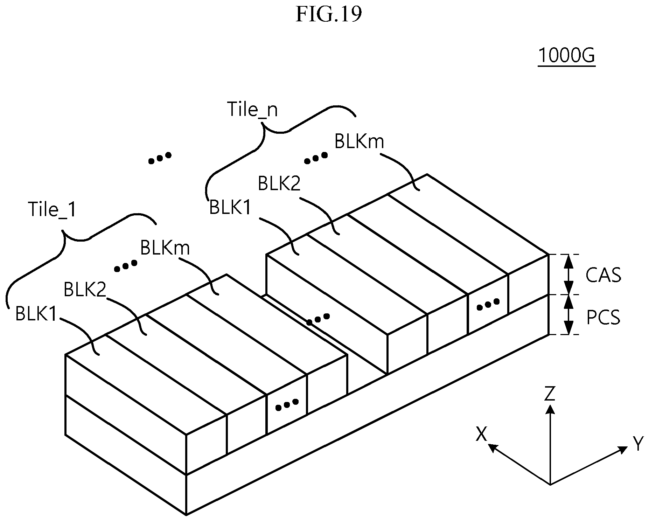

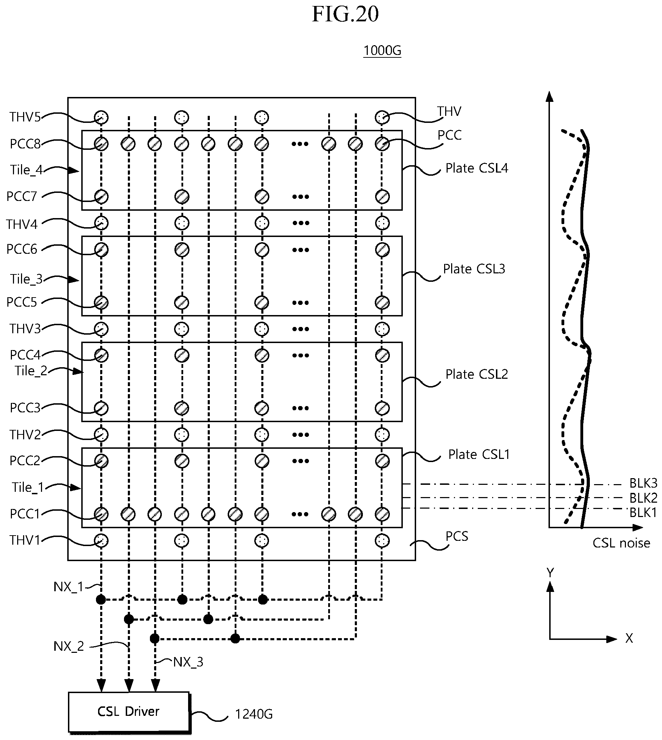

FIG. 19 illustrates a schematic perspective view of an example memory device 1000G according to an embodiment, and FIG. 20 illustrates a plan view of the example memory device 1000G of FIG. 19.

The memory device 1000G of FIGS. 19 and 20 is similar to the memory devices 1000A to 1000F of FIGS. 1 to 18. Therefore, the same or similar components are denoted by the same or similar reference numerals, and redundant descriptions will be omitted below. For ease of description, in the present embodiment of FIG. 20, the memory device 1000G may include four tiles.

Referring to FIG. 19, the memory device 1000G may include a cell array structure CAS and a peripheral circuit structure PCS overlapping each other in a vertical direction (a Z-direction).

The cell array structure CAS may include a plurality of tiles Tile_1 to Tile_n. Each tile may be implemented to include a plurality of memory blocks. Each tile may be implemented to include, for example, a single plate CSL.

Referring to FIG. 20, the memory device 1000G according to an example embodiment may include a plurality of column networks NX_1 to NX_3 to discharge the plate CSLs Plate CSL1 to Plate CSL4. Each of the plurality of column networks NX_1 to NX_3 may be formed across the tiles Tile_1 to Tile_4, and may be connected to a CSL driver 1240G through plate common source contacts PCCs and through-vias THVs. For example, the first column network NX_1 may be electrically connected to the first to fourth plate CSLs Plate CSL1 to Plate CSL4 through through-vias THV1 to THV5 and the first to eighth plate common source contacts PCC1 to PCC8.

The CSL driver 1240G includes, for example, a plurality of CSL driving units, and each of the plurality of CSL driving units may be controlled independently of each other. Accordingly, the memory device 1000G according to an example embodiment may improve not only a CSL noise skew between memory blocks but also a CSL noise skew between tiles.

In FIG. 20, the memory device 1000G is illustrated as including only a plurality of column networks. However, this is merely an example, and the memory device 1000G may include a plurality of row networks, or may include both a plurality of column networks and a plurality of row networks.

As set forth above, a memory device according to example embodiments may have an improved CSL noise skew.

While example embodiments have been shown and described above, it will be apparent to those skilled in the art that modifications and variations could be made without departing from the scope of the present inventive concept as defined by the appended claims.

## Claims

1. A memory device comprising:
a stack structure in which a common source line is formed; and
a peripheral circuit structure overlapping the stack structure when viewed in plan view and comprising a common source line driver configured to discharge the common source line,
wherein
the common source line driver comprises:
a first common source line driving unit electrically connected to the common source line through a first network and configured to discharge the common source line; and
a second common source line driving unit electrically connected to the common source line through a second network, different from the first network, and configured to discharge the common source line, and
the first common source line driving unit and the second common source line driving unit are controlled independently of each other.

2. The memory device of claim 1, further comprising:
a first through-via connected to the first common source line driving unit through the stack structure;
a first plate common source contact connected to the common source line through the stack structure; and
a first metal interconnection formed in the stack structure and connecting the first through-via and the first plate common source contact to each other.

3. The memory device of claim 2, further comprising:
a second through-via connected to the second common source line driving unit through the stack structure;
a second plate common source contact connected the common source line through the stack structure; and
a second metal interconnection formed in the stack structure and connecting the second through-via and the second plate common source contact to each other.

4. The memory device of claim 3, wherein
the first network comprises the first through-via, the first plate common source contact, and the first metal interconnection,
the second network comprises the second through-via, the second plate common source contact, and the second metal interconnection,
the first common source line driving unit is turned on based on a first network control signal to connect the first network to a ground terminal, and
the second common source line driving unit is turned on based on a second network control signal, different from the first network control signal, to connect the second network to a ground terminal.

5. The memory device of claim 4, wherein
the first through-via and the second through-via are disposed outside the common source line when viewed in plan view,
the first plate common source contact and the second plate common source contact overlap the common source line when viewed in plan view, and
the first metal interconnection and the second metal interconnection partially overlap the common source line when viewed in plan view

6. The memory device of any of claims 2 to 5, wherein
the stack structure comprises:
a first memory block formed on the common source line and spaced apart from the first plate common source contact by a first distance; and
a second memory block formed on the common source line and spaced apart from the second plate common source contact by a second distance, greater than the first distance,
the first common source line driving unit and the second common source line driving unit are respectively turned on and turned off during a discharge operation on a region, corresponding to the first memory block, of the common source line, and
the first common source line driving unit and the second common source line driving unit are all turned on during a discharge operation on a region, corresponding to the second memory block, of the common source line.

7. The memory device of any of claims 2 to 6, wherein
the stack structure comprises:
a first bitline formed on the common source line and spaced apart from the first plate common source contact by a first distance; and
a second bitline formed on the common source line and spaced apart from the first plate common source contact by a second distance, greater than the first distance,
the first common source line driving unit and the second common source line driving unit are respectively turned on and turned off during a discharge operation on a region, corresponding to the first bitline, of the common source line, and
the first common source line driving unit and the second common source line driving unit are turned on during a discharge operation on a region, corresponding to the second bitline, of the common source line.

8. The memory device of any preceding claim, wherein
the peripheral circuit structure comprises a control logic,
the first common source line driving unit is turned on or turned off in response to a first network control signal received from the control logic,
the second common source line driving unit is turned on or turned off in response to a second network control signal received from the control logic, and
the first network control signal or the second network control signal has a variable voltage level.

9. The memory device of any preceding claim, wherein
the first common source line driving unit is connected between the first network and a ground terminal and is turned on or turned off in response to a network control signal, and
the second common source line driving unit is connected between the first network and the second network and is turned on or turned off in response a switch control signal.

10. The memory device of any preceding claim, wherein
the first common source line driving unit is connected between the first network and a ground terminal and is turned on or turned off in response to a network control signal, and
the second common source line driving unit is a transistor connected between the first network and the second network, and a gate and a source of the second common source line driving unit are connected to each other.

11. A memory device comprising:
a common source line; and
a common source line driver connected to the common source line through a plurality of networks and configured to discharge the common source line,
wherein
the common source line driver selectively activates the plurality of networks based on a physical location of a discharged region of the common source line.

12. The memory device of claim 11, further comprising:
a plurality of memory blocks disposed on the common source line,
wherein
the common source line driver selectively activates the plurality of networks based on a physical location of a selected memory block, among the plurality of memory blocks.

13. The memory device of claim 12, wherein
a number of activated networks is decreased as a distance between the selected memory block and the common source line driver is decreased.

14. The memory device of any of claims 11 to 13, further comprising:
a plurality of bitlines disposed on the common source line,
wherein
the common source line driver selectively activates the plurality of networks based on a physical location of a selected bitline, among the plurality of bitlines.

15. The memory device of claim 14, wherein
a number of activated networks is decreased as a distance between the selected bitline and the common source line driver is decreased.
